# FASCICULE DE BREVET EUROPEEN

(11) **EP 2 545 588 B1**
(45) Date de publication et mention de la délivrance du brevet: **01.01.2014**
(21) Numéro de dépôt: 11712955.1
(22) Date de dépôt: 02.03.2011
(51) Int. Cl.: H01L 31/02, H01L 31/0224, H01L 31/18

(54) **SUBSTRAT TRANSPARENT VERRIER ASSOCIE A UNE COUCHE ELECTROCONDUCTRICE TRANSPARENTE A PROPRIETES ELECTRIQUES AMELIOREES**
TRANSPARENTES GLASSUBSTRAT IN KOMBINATION MIT EINER TRANSPARENTEN ELEKTRISCH LEITENDEN SCHICHT MIT VERBESSERTEN ELEKTRISCHEN EIGENSCHAFTEN
TRANSPARENT GLASS SUBSTRATE COMBINED WITH TRANSPARENT ELECTRICALLY CONDUCTIVE LAYER HAVING IMPROVED ELECTRICAL PROPERTIES

(30) Priorité: 12.03.2010 FR 1051780
(43) Date de publication de la demande: 16.01.2013
(73) Titulaire: Saint-Gobain Glass France, 92400 Courbevoie (FR)
(72) Inventeur: PETER, Emmanuelle, F-13090 Aix En Provence (FR); ALBIZZATI, Bastien, F-75012 Paris (FR); LECAMP, Guillaume, F-75018 Paris (FR)
(74) Mandataire: Ribeaudeau, Marion Christine
(86) Numéro de dépôt international: PCT/FR2011/050437
(87) Numéro de publication internationale: WO 2011/110773

(56) Documents cités:
- EP-A1- 1 950 813
- GB-A- 2 252 332
- US-A1- 2005 000 564
- US-A1- 2007 169 805
- HITOSUGI T ET AL: "Transparent conducting properties of anatase Ti0.94Nb0.06O2 polycrystalline films on glass substrate", THIN SOLID FILMS, ELSEVIER-SEQUOIA S.A. LAUSANNE, CH LNKD- DOI:10.1016/J.TSF.2007.10.028, vol. 516, no. 17, 1 juillet 2008 (2008-07-01), pages 5750-5753, XP022688386, ISSN: 0040-6090 [extrait le 2007-10-16]

## Description

L'invention se rapporte à un substrat de face avant de module photovoltaïque, notamment un substrat verrier transparent, ainsi qu'à un module photovoltaïque incorporant un tel substrat. Le document T. Hitosugi et al., THIN SOLID FILMS, vol 516, no. 17, pages 5750-5753 décrit un substrat transparent verrier.

Dans un module photovoltaïque, un système photovoltaïque à matériau photovoltaïque qui produit de l'énergie électrique sous l'effet d'un rayonnement incident est positionné entre un substrat de face arrière et un substrat de face avant, ce substrat de face avant étant le premier substrat qui est traversé par le rayonnement incident avant qu'il n'atteigne le matériau photovoltaïque.

On entend par matériaux photovoltaïques des agents absorbeurs pouvant être composés par exemple de tellure de cadmium, de silicium amorphe, de silicium microcristallin ou de ternaires chalcopyrites qui contiennent généralement du cuivre, de l'indium et du sélénium pouvant éventuellement être utilisés en combinaison dans des jonctions multiples. Il s'agit là de ce que l'on appelle des couches d'agent absorbeur CISe₂. On peut aussi ajouter à la couche d'agent absorbeur du gallium (ex : Cu(In,Ga)Se₂ ou CuGaSe₂), de l'aluminium (ex : Cu(In,Al)Se₂), ou du soufre (ex : CuIn(Se,S). On les désigne en général par le terme de couches d'agent absorbeur à chalcopyrite.

Dans le module photovoltaïque, le substrat de face avant comporte d'une manière habituelle en dessous d'une surface principale tournée vers le matériau photovoltaïque un revêtement électrode transparent en contact électrique avec le matériau photovoltaïque disposé dessous lorsque l'on considère que la direction principale d'arrivée du rayonnement incident est par le dessus.

Au sens de la présente invention, il faut comprendre par « module photovoltaïque » tout ensemble de constituants générant la production d'un courant électrique entre ses électrodes par conversion de rayonnement solaire, quelles que soient les dimensions de cet ensemble et quelles que soient la tension et l'intensité du courant produit et en particulier que cet ensemble de constituants présente, ou non, un ou plusieurs raccordement(s) électrique(s) interne(s) (en série et/ou en parallèle). La notion de « module photovoltaïque » au sens de la présente invention est donc ici équivalente à celle de « cellule photovoltaïque » ou encore de « panneau photovoltaïque ».

La présente invention a trait aux couches électroconductrices transparentes, notamment à base d'oxydes, d'un grand intérêt sur substrat verrier.

Des exemples en sont des couches ITO (indium tin oxide) d'oxyde d'indium dopé à l'étain, des couches SnO₂:F d'oxyde d'étain dopé au fluor. De telles couches constituent des électrodes dans certaines applications : lampes planes, vitrage électroluminescent, vitrage électrochrome, écran d'affichage à cristaux liquides, écran plasma, panneau ou module photovoltaïque, verres chauffants. Dans d'autres applications pour des vitrages bas-émissifs, par exemple, ces couches conductrices transparentes n'ont pas à être mises sous tension électrique.

Les inventeurs ont à présent élaboré des couches électroconductrices transparentes aptes à constituer des électrodes de modules photovoltaïques à propriétés électriques améliorées.

On s'intéresse particulièrement aux électrodes avant des cellules couches minces à base de silicium (silicium amorphe, silicium microcristallin ou des combinaisons de ces deux matériaux absorbeurs dans des structures tandem, triple-jonction, multiple jonctions, en configuration deux fils ou quatre fils) ou plus généralement de tout matériau absorbeur nécessitant de compenser leur faible épaisseur (couches minces) par un piégeage de la lumière, obtenu par texturation.

On caractérise les cellules photovoltaïques au moyen du modèle d'un circuit électrique équivalent pour une cellule solaire (« solar cell equivalent circuit » en anglais) ; les mesures sont effectuées dans les conditions standard, c'est-à-dire à une température de 25 °C et une irradiance de 1000 W/m² selon le spectre AM 1.5.

Ainsi :
- Jsc est la valeur en mA/cm² de densité de courant générée par la cellule solaire, à zéro volt (densité de courant correspondant à un court-circuit) ;
- Voc est la tension en volts en circuit ouvert (« open circuit voltage » en anglais) ; et
- FF (« fill factor » en anglais) est, en %, la puissance maximale de la cellule photovoltaïque divisée par Jsc et Voc.

D'autre part, la texture de la couche électroconductrice transparente est caractérisée usuellement macroscopiquement par le flou et microscopiquement par sa valeur rms. Dans la présente demande, on définit la rms de la couche électroconductrice transparente comme l'écart-type de la distribution des hauteurs sur une image AFM de sa surface de 10 µm x 10 µm.

Des rms trop élevées dégradent les performances électriques (Voc, FF) toutes choses égales par ailleurs. Les performances optimales d'une cellule résultent donc d'un compromis entre le Jsc et le Voc, ce qui limite les valeurs de rms visées pour la texture typiquement entre 20 et 200 nm.

L'invention consiste à améliorer ce compromis, en proposant des textures, qui à rms équivalentes améliorent le Voc.

A cet effet, l'invention a pour objet un substrat transparent verrier, associé à une couche électroconductrice transparente apte à constituer une électrode de module photovoltaïque et composée d'un oxyde dopé, qui se distingue par le fait que
- par prise, sur une surface de 2 cm x 2 cm, d'au moins cinq images par microscopie à force atomique (AFM) de 10 µm x 10 µm (512 pixels x 512 pixels) de la face de ladite couche électroconductrice transparente opposée audit substrat transparent verrier, au moyen d'une pointe AFM de rayon de courbure au plus égal à 10 nm,
- puis pour chacune des au moins cinq images, calcul par interpolation bilinéaire de toutes les courbes de niveaux avec un pas de 1 nm à un taux de suréchantillonnage de 4 points par pixel, en ne gardant que celles délimitant une région contenant un seul maximum local, aucun minimum local, et fermées,
- la moyenne des valeurs obtenues pour les au moins cinq images du ratio isopérimétrique moyen (RIm) défini pour des aires des courbes de niveaux comprises entre 2000 nm² et 8000 nm² comme le périmètre de ces courbes de niveaux au carré divisé par 4 fois n fois leur aire, est au plus égale à 1,17, et
- la moyenne des valeurs obtenues pour les au moins cinq images de l'écart-type de la distribution des hauteurs (rms) est comprise entre 20 et 200 nm.

Les courbes de niveaux relient des points de la surface de mêmes hauteurs ou altitudes. Le terme maximum désigne un maximum local de hauteur, autrement dit un sommet.

Préalablement au calcul des courbes de niveaux, on supprime le cas échéant les maxima locaux aberrants ; ce n'est cependant indiqué que si l'image AFM est de relativement mauvaise qualité.

Le pas de 1 nm exprime la différence de hauteur, c'est-à-dire dans la direction perpendiculaire au plan principal de la couche électroconductrice transparente (et du substrat transparent verrier), de deux courbes de niveaux successives.

A chaque pixel est donc associée dans un premier temps une hauteur unique. Dans un second temps, l'interpolation bilinéaire permet de calculer les courbes de niveaux avec un pas de 1 nm.

Dans chaque carré élémentaire délimité par quatre pixels voisins, chaque segment des courbes de niveaux inscrit dans ce carré est défini à partir de quatre valeurs de subdivisions de ce segment, c'est-à-dire constitué à partir de quatre sous-segments. Ce suréchantillonnage permet d'avoir des estimations plus fines du périmètre des courbes.

Sont donc éliminées à la fois les courbes de niveaux délimitant des régions contenant deux maxima locaux ou plus, un minimum local ou plus, et celles qui ne sont pas fermées, localisées en bord de la surface traitée de 10 µm x 10 µm.

Le ratio isopérimétrique moyen tel que défini ci-dessus est nécessairement au moins égal à 1, et d'autant plus proche de cette valeur que la géométrie de la courbe de niveau est proche de celle d'un cercle ; il est d'autant plus élevé que la géométrie de la courbe de niveau est complexe, présente des circonvolutions. Or les inventeurs se sont aperçus que plus ce ratio isopérimétrique moyen est proche de 1, meilleures sont les propriétés électriques de la couche électroconductrice transparente, ainsi que notamment du module photovoltaïque dans la constitution duquel entre cette couche.

Pour la première fois, les inventeurs ont ainsi pu élaborer une couche électroconductrice transparente de ratio isopérimétrique moyen au plus égal à 1,17, et même sensiblement plus faible, combiné à une rms de 20 à 200 nm.

Ainsi, selon des caractéristiques classées par ordre de préférence croissant, le substrat de l'invention présente un ratio isopérimétrique moyen au plus égal à 1,16, 1,15, 1,14, 1,13, 1,12.

Selon d'autres caractéristiques préférées du substrat de l'invention :
- ledit écart-type de la distribution des hauteurs (rms) est au plus égal à 100 nm, de préférence à 70 nm, de préférence au moins égal à 30 nm ;
- la couche électroconductrice transparente est composée d'un oxyde dopé de Sn, Zn ou In, tel que SnO₂:F, SnO₂:Sb, ZnO :Al, ZnO :Ga, InO : Sn, ZnO :B ou ZnO :In, de préférence SnO₂ : F;
- la couche électroconductrice transparente composée d'un oxyde dopé recouvre directement une couche du même oxyde non dopé, l'épaisseur cumulée des deux couches de l'oxyde non dopé et de l'oxyde dopé étant comprise entre 300 et 1600 nm, de préférence au plus égale à 1100 nm et de manière particulièrement préférée à 900 nm, et le rapport des épaisseurs des deux couches étant compris entre 1:4 et 4:1 ; la présence de ladite couche de l'oxyde non dopé est facultative, et en cas d'absence de celle-ci, l'épaisseur de la couche électroconductrice transparente est égale à l'épaisseur cumulée telle que définie précédemment ;
- entre le substrat transparent verrier et la couche électroconductrice transparente est interposée au moins une couche d'au moins un nitrure ou oxynitrure, ou oxyde ou oxycarbure ;
- une couche barrière vis-à-vis de la migration des alcalins du verre et à bonne adhésion à celui-ci recouvre directement le substrat transparent verrier ; elle est elle-même notamment constituée d'au moins un nitrure ou oxynitrure, ou oxyde ou oxycarbure, et avantageusement d'une couche d'oxycarbure de silicium SiOC d'épaisseur comprise entre 5 et 80 nm ; entre cette couche barrière et la couche électroconductrice transparente peut être interposée au moins une couche d'au moins un nitrure ou oxynitrure, ou oxyde ou oxycarbure ;
- une couche mixte d'un composé d'un élément chimique minéral constitutif de la couche barrière et d'un élément chimique minéral constitutif de la couche électroconductrice transparente recouvre directement la couche barrière ; il s'agit de préférence d'une couche d'oxyde de silicium et d'étain d'épaisseur comprise entre 3 et 65 nm ; cependant une telle couche mixte peut ne pas être présente.

Un autre objet de l'invention consiste en un procédé de fabrication d'un substrat tel que décrit ci-dessus, dans lequel les éventuelles couche barrière, couche mixte et couche de l'oxyde constitutif de la couche électroconductrice transparente non dopé, et la couche électroconductrice transparente, sont obtenues par dépôts successifs par voie chimique en phase vapeur.

Le dépôt par voie chimique en phase vapeur (CVD pour Chemical Vapour Deposition) peut être facilement mis en oeuvre à l'échelle industrielle sur de grandes surfaces de verre, en particulier sur Pleine Largeur Float (PLF). Il ne nécessite aucune installation sous vide.

Citons,
- comme précurseur de SiO₂ (SiOC - SiOSn) : tétraéthoxysilane (TEOS), hexaméthyldisiloxane (HMDSO), silane (SiH₄) ;
- comme précurseur de SnO₂ (SiOSn, SnO₂, SnO₂:F): trichlorure de monobutylétain (MBTCl), diacétate de dibutylétain (DBTA), tétrachlorure d'étain (SnCl₄), dichlorure de dibutylétain (DBTCl) ;
- comme autre précurseur carboné (SiOC) : éthylène, dioxyde de carbone ;
- comme autre précurseur oxygéné (SiOC, SiOSn, SnO₂, SnO₂ : F) : dioxyde de carbone, oxygène, eau ;
- comme précurseur fluoré (SnO₂: F) : tétrafluorométhane (CF4), octafluoropropane (C3F8), hexafluoroéthane (C2F6), fluorure d'hydrogène (HF), difluoro-chloro-méthane (CHCIF₂), difluoro-chloro-éthane (CH₃CCIF₂), trifluorométhane (CHF₃), dichlorodifluorométhane (CF₂Cl₂), trifluoro-chlorométhane (CF₃Cl), trifluorobromométhane (CF₃Br), acide trifluoroacétique (TFA, CF₃COOH), trifluorure d'azote (NF₃).

Lesdits dépôts successifs sont avantageusement effectués à une température du substrat au moins égale à 500°C, pouvant atteindre des valeurs de 650°C ou plus.

Par exemple, une ou plusieurs couches sous-jacentes peut (peuvent) être déposée(s) sur la ligne de production du substrat verrier puis une ou plusieurs couche(s) sur-jacente(s) en dehors de cette ligne de production, ou bien toutes ces couches peuvent être déposées en dehors de cette ligne de production.

Cependant, selon une réalisation préférée du procédé, lesdits dépôts successifs par voie chimique en phase vapeur sont effectués sur la ligne de production du substrat verrier, par exemple sur ruban continu dans la partie comprenant le float, l'exit et le début de l'étenderie.

L'invention a d'autre part pour objets :
- un module photovoltaïque comprenant un substrat décrit ci-dessus ;
- un verre chauffant mis en forme, comprenant un substrat tel que décrit précédemment ;
- une électrode de lampe plane comprenant un tel substrat.
- un dispositif à diodes électroluminescentes organiques (oleds) comprenant un tel substrat.

L'invention est maintenant illustrée par les exemples suivants.

### EXEMPLES

On réalise quatre cellules photovoltaïques de 2 cm x 2 cm, ne se différenciant que par la couche électroconductrice transparente constituant leur électrode avant.

La couche photovoltaïque est de type silicium amorphe a-Si.

La résistance de la couche électroconductrice transparente est ajustée à une valeur précisée ci-dessous, comprise entre 8 et 10 ohms/□.

Un substrat de face arrière est rapporté sur l'électrode arrière, du type argent, par l'intermédiaire d'un feuillet éthylène-acétate de vinyle (EVA).

On constitue quatre cellules incorporant chacune une couche électroconductrice transparente, obtenue par dépôt par voie chimique en phase vapeur des proportions suivantes, exprimées en % molaire, de précurseurs.

### Exemples 1 et 2 :

| | |
|---|---|
| trichlorure de monobutylétain (MBTCl) | 3,14 |
| acide trifluoroacétique (TFA) | 0,35 |
| eau | 43 |
| N₂ | 41 |
| O₂ | 12 |

L'épaisseur de la couche conductrice transparente est 900 nm à l'exemple 1, 750 nm à l'exemple 2.

### Exemples 3 et 4 :

| | |
|---|---|
| SnCl₄ | 0,21 |
| NF₃ | 3,41 |
| eau | 1,22 |
| N₂ | 86,65 |
| O₂ | 8,52. |

L'épaisseur de la couche électroconductrice transparente est 900 nm à l'exemple 3, 750 nm à l'exemple 4.

Dans les quatre exemples, la couche électroconductrice transparente est en SnO₂: F.

Après formation de cette couche électroconductrice transparente mais avant formation sur celle-ci d'autres constituants de la cellule, on en prend une image au microscope à force atomique (AFM) de la surface. Cette image de 10 µm x 10 µm (512 x 512 pixels) est éventuellement débruitée, c'est-à-dire qu'en sont enlevés d'éventuels maxima locaux (de hauteur) aberrants. Cependant l'image est ici de bonne qualité, de sorte qu'un tel débruitage est inutile.

On calcule par interpolation bilinéaire toutes les courbes de niveaux avec un pas de 1 nm (hauteur séparant deux courbes de niveaux consécutives) et avec un taux de suréchantillonnage de 4 points par pixel (c'est-à-dire que dans chaque carré élémentaire délimité par quatre pixels voisins, chaque segment de courbe de niveau est déterminé par le calcul à partir de quatre points).

On ne prend en considération ni les courbes de niveaux englobant plus d'un maximum, ni celles qui ne sont pas fermées, c'est-à-dire dont une partie seulement est inscrite dans la surface de 10 µm x 10 µm de l'image.

Pour les courbes de niveaux d'aires comprises entre 2000 et 8000 nm², on désigne par P leur périmètre, et A leur aire, on définit alors le ratio isopérimétrique moyen (RIm) égal à P²/4ΠA.

On relève cinq fois la valeur de RIm sur toute la surface de 2 cm x 2 cm de la cellule, et l'on effectue la moyenne de ces cinq valeurs.

On trouve ainsi

| Exemples N° | RIm |
|---|---|
| 1 | 1,1456 |
| 2 | 1,1133 |
| 3 | 1,3635 |
| 4 | 1,2154 |

Seuls les exemples 1 et 2 sont donc conformes à l'invention.

On relève par ailleurs ci-dessous la résistance R/□ (ohms/□) de la couche électroconductrice transparente

On caractérise d'autre part le substrat de face avant de la cellule (verre - empilement classique comprenant une couche barrière et se terminant par la couche électroconductrice transparente) par plusieurs paramètres.

On détermine la transmission Tsqe en effectuant l'intégration du produit des spectres de transmission du substrat comprenant la couche électroconductrice transparente, par le spectre solaire AM 1.5, et par le spectre d'efficacité quantique externe du matériau photovoltaïque considéré, par exemple a-Si. Cette intégration est ensuite normalisée par l'intégration du produit des spectres solaires AM 1.5 par le spectre d'efficacité quantique externe du matériau photovoltaïque.

On rappelle que l'efficacité quantique externe EQE est d'une manière connue l'expression de la probabilité (entre 0 et 1) qu'un photon incident à la longueur d'onde considérée soit transformé en paire électron-trou pour le matériau photovoltaïque considéré, collectée par les électrodes.

La transmission lumineuse totale d'un élément, TL, qui comprend la transmission lumineuse directe et la transmission lumineuse diffuse, est déterminée selon la norme ISO 9050:2003.

De plus, on entend par valeur de flou (« haze » en anglais) d'un élément, exprimée en pourcentage, une grandeur représentative de l'aptitude de cet élément à dévier un rayonnement. Dans cette demande, les valeurs de flou sont mesurées au hazemeter selon la norme ASTM D 1003.

Comme déjà mentionné précédemment, la rms de la couche électroconductrice transparente est définie comme la moyenne sur 5 images AFM de 10 µm x 10 µm de sa surface de l'écart-type de la distribution des hauteurs.

Les valeurs sont consignées dans le Tableau 1 ci-dessous.

**Tableau 1**

| Exemples N° | 1 | 2 | 3 | 4 |
|---|---|---|---|---|
| R/□ (Ω/□) | 9 | 9,9 | 8,7 | 9,3 |
| Tsqe a-Si (%) | 83,9 | 83,8 | 84,2 | 85,1 |
| TL (%) | 80,9 | 80,4 | 81,5 | 82 |
| Flou (%) | 8,9 | 15,3 | 13,4 | 16,8 |
| Rms (nm) | 40 | 52 | 47 | 45 |

On caractérise les cellules photovoltaïques au moyen du modèle d'un circuit électrique équivalent pour une cellule solaire (« solar cell equivalent circuit » en anglais) ; les mesures sont effectuées dans les conditions standard, c'est-à-dire à une température de 25 °C et une irradiance de 1000 W/m² selon le spectre AM 1.5.

Il est précisé que la cellule comporte de manière connue, une couche p, une couche i et une couche n.
- L'épaisseur de la couche p est approximativement de 5-10 nm.
- La couche i est une couche de a-Si de 250 nm d'épaisseur environ.
- La couche n a une épaisseur de 15 nm.

Ainsi :
- Jsc est la valeur en mA/cm² de densité de courant générée par la cellule solaire, à zéro volt (densité de courant correspondant à un court-circuit) ;
- Voc est la tension en volts en circuit ouvert (« open circuit voltage » en anglais) ;
- FF (« fill factor » en anglais) est, en %, la puissance maximale de la cellule photovoltaïque divisée par Jsc et Voc ; et
- L'efficacité en % est le produit de Jsc par Voc par FF.

Les valeurs consignées dans le Tableau 2 ci-dessous sont chaque fois des valeurs moyennes déterminées à partir de vingt cellules.

**Tableau 2**

| Exemples N° | 1 | 2 | 3 | 4 |
|---|---|---|---|---|
| Jsc (mA/cm²) | 12,1 | 12,2 | 12,5 | 13 |
| Voc (V) | 0,871 | 0,877 | 0,844 | 0,842 |
| FF (%) | 62,7 | 61,2 | 55,5 | 58 |
| Efficacité (%) | 6,61 | 6,55 | 5,86 | 6,35 |

On constate que les cellules photovoltaïques comprenant un substrat avant selon l'invention (exemples 1 et 2) ont de meilleures propriétés électriques que celles des exemples 3 et 4, et notamment un Voc et une efficacité supérieurs pour des rms équivalentes (comprises entre 40 à 52 nm)

## Revendications

1. Substrat transparent verrier, associé à une couche électroconductrice transparente apte à constituer une électrode de module photovoltaïque et composée d'un oxyde dopé, qui se distingue par le fait que
- par prise, sur une surface de 2 cm x 2 cm, d'au moins cinq images par microscopie à force atomique (AFM) de 10 µm x 10 µm (512 pixels x 512 pixels) de la face de ladite couche électroconductrice transparente opposée audit substrat transparent verrier, au moyen d'une pointe AFM de rayon de courbure au plus égal à 10 nm,
- puis pour chacune des au moins cinq images, calcul par interpolation bilinéaire de toutes les courbes de niveaux avec un pas de 1 nm à un taux de suréchantillonnage de 4 points par pixel, en ne gardant que celles délimitant une région contenant un seul maximum local, aucun minimum local, et fermées,
- la moyenne des valeurs obtenues pour les au moins cinq images du ratio isopérimétrique moyen (Rlm) défini pour des aires des courbes de niveaux comprises entre 2000 nm² et 8000 nm² comme le périmètre de ces courbes de niveaux au carré divisé par 4 fois n fois leur aire, est au plus égale à 1,17, et
- la moyenne des valeurs obtenues pour les au moins cinq images de l'écart-type de la distribution des hauteurs (rms) est comprise entre 20 et 200 nm, **caractérisé en ce que** la couche électroconductrice transparente composée d'un oxyde dopé recouvre directement une couche du même oxyde non dopé, l'épaisseur cumulée des deux couches de l'oxyde non dopé et de l'oxyde dopé étant comprise entre 300 et 1600 nm, de préférence au plus égale à 1100 nm et de manière particulièrement préférée à 900 nm, et le rapport des épaisseurs des deux couches étant compris entre 1:4 et 4:1.

2. Substrat selon la revendication 1, **caractérisé en ce que** le ratio isopérimétrique moyen est au plus égal à 1,16.

3. Substrat selon l'une quelconque des revendications précédentes, **caractérisé en ce que** le ratio isopérimétrique moyen est au plus égal à 1,15.

4. Substrat selon l'une quelconque des revendications précédentes, **caractérisé en ce que** le ratio isopérimétrique moyen est au plus égal à 1,14.

5. Substrat selon l'une quelconque des revendications précédentes, **caractérisé en ce que** le ratio isopérimétrique moyen est au plus égal à 1,13.

6. Substrat selon l'une quelconque des revendications précédentes, **caractérisé en ce que** le ratio isopérimétrique moyen est au plus égal à 1,12.

7. Substrat selon l'une quelconque des revendications précédentes, **caractérisé en ce que** l'écart-type de la distribution des hauteurs (rms) est au plus égal à 100, de préférence 70 nm.

8. Substrat selon l'une quelconque des revendications précédentes, **caractérisé en ce que** l'écart-type de la distribution des hauteurs (rms) est au moins égal à 30 nm.

9. Substrat selon l'une quelconque des revendications précédentes, **caractérisé en ce que** la couche électroconductrice transparente est composée d'un oxyde dopé de Sn, Zn ou In, tel que SnO₂:F, SnO₂:Sb, ZnO :Al, ZnO :Ga, InO :Sn, ZnO :B ou ZnO :In.

10. Substrat selon l'une quelconque des revendications précédentes, **caractérisé en ce que** la couche électroconductrice transparente est composée de SnO₂ :F.

11. Substrat selon l'une quelconque des revendications précédentes, **caractérisé en ce qu'**entre le substrat transparent verrier et la couche électroconductrice transparente est interposée au moins une couche d'au moins un nitrure ou oxynitrure, ou oxyde ou oxycarbure.

12. Substrat selon l'une quelconque des revendications précédentes, **caractérisé en ce qu'**une couche barrière vis-à-vis de la migration des alcalins du verre et à bonne adhésion à celui-ci recouvre directement le substrat transparent verrier.

13. Substrat selon la revendication 12, **caractérisé en ce qu'**une couche mixte d'un composé d'un élément chimique minéral constitutif de la couche barrière et d'un élément chimique minéral constitutif de la couche électroconductrice transparente recouvre directement la couche barrière.

14. Substrat selon l'une quelconque des revendications 12 ou 13, **caractérisé en ce que** la couche barrière est en oxycarbure de silicium SiOC d'épaisseur comprise entre 5 et 80 nm.

15. Substrat selon l'une quelconque des revendications 13 à 14, **caractérisé en ce que** la couche mixte est en oxyde de silicium et d'étain d'épaisseur comprise entre 3 et 65 nm.

16. Procédé de fabrication d'un substrat selon l'une quelconque des revendications précédentes, **caractérisé en ce que** les éventuelles couche barrière, couche mixte et couche de l'oxyde constitutif de la couche électroconductrice transparente non dopé, et la couche électroconductrice transparente sont obtenues par dépôts successifs par voie chimique en phase vapeur.

17. Module photovoltaïque comprenant un substrat selon l'une quelconque des revendications 1 à 15.

18. Verre chauffant mis en forme, comprenant un substrat selon l'une quelconque des revendications 1 à 15.

19. Electrode de lampe plane comprenant un substrat selon l'une quelconque des revendications 1 à 15.

20. Dispositif à diodes électroluminescentes organiques comprenant un substrat selon l'une quelconque des revendications 1 à 15.

## Patentansprüche

1. Transparentes Glassubstrat, das einer transparenten, elektrisch leitenden Schicht, welche geeignet ist, eine Elektrode eines Photovoltaikmoduls zu bilden, und aus einem dotierten Oxid besteht, zugeordnet ist, das sich dadurch unterscheidet, dass
- durch Aufnahme, auf einer Fläche von 2 cm x 2 cm, von wenigstens fünf Bildern durch Rasterkraftmikroskopie (AFM) von 10 µm x 10 µm (512 Pixel x 512 Pixel) der dem transparenten Glassubstrat gegenüberliegenden Seite der transparenten, elektrisch leitenden Schicht, mittels einer AFM-Spitze mit einem Krümmungsradius von höchstens gleich 10 nm,
- anschließend, für jedes der wenigstens fünf Bilder, Berechnung mittels bilinearer Interpolation aller Niveaulinien mit einem Abstand von 1 nm bei einer Überabtastungsrate von 4 Punkten pro Pixel, indem lediglich diejenigen behalten werden, die einen ein einziges lokales Maximum, keinerlei lokales Minimum, enthaltenden Bereich begrenzen und geschlossen sind,
- der Mittelwert der für die wenigstens fünf Bilder erhaltenen Werte des mittleren isoperimetrischen Verhältnisses (RIm), definiert für Flächeninhalte der Niveaulinien zwischen 2000 nm² und 8000 nm² als der Umfang dieser Niveaulinien im Quadrat dividiert durch 4 Mal das n-fache ihres Flächeninhalts, höchstens gleich 1,17 beträgt, und
- der Mittelwert der für die wenigstens fünf Bilder erhaltenen Werte der Standardabweichung der Höhenverteilung (rms) zwischen 20 und 200 nm liegt, **dadurch gekennzeichnet, dass** die transparente, elektrisch leitende, aus einem dotierten Oxid bestehende Schicht direkt eine Schicht aus dem gleichen, nicht dotierten Oxid bedeckt, wobei die kumulierte Dicke der beiden Schichten aus dem nicht dotierten Oxid und aus dem dotierten Oxid zwischen 300 und 1600 nm, vorzugsweise höchstens gleich 1100 nm und besonders bevorzugt 900 nm beträgt, und wobei das Verhältnis der Dicken der beiden Schichten zwischen 1 : 4 und 4 : 1 liegt.

2. Substrat nach Anspruch 1, **dadurch gekennzeichnet, dass** das mittlere isoperimetrische Verhältnis höchstens gleich 1,16 beträgt.

3. Substrat nach einem der vorstehenden Ansprüche, **dadurch gekennzeichnet, dass** das mittlere isoperimetrische Verhältnis höchstens gleich 1,15 beträgt.

4. Substrat nach einem der vorstehenden Ansprüche, **dadurch gekennzeichnet, dass** das mittlere isoperimetrische Verhältnis höchstens gleich 1,14 beträgt.

5. Substrat nach einem der vorstehenden Ansprüche, **dadurch gekennzeichnet, dass** das mittlere isoperimetrische Verhältnis höchstens gleich 1,13 beträgt.

6. Substrat nach einem der vorstehenden Ansprüche, **dadurch gekennzeichnet, dass** das mittlere isoperimetrische Verhältnis höchstens gleich 1,12 beträgt.

7. Substrat nach einem der vorstehenden Ansprüche, **dadurch gekennzeichnet, dass** die Standardabweichung der Höhenverteilung (rms) höchstens gleich 100, vorzugsweise 70 nm beträgt.

8. Substrat nach einem der vorstehenden Ansprüche, **dadurch gekennzeichnet, dass** die Standardabweichung der Höhenverteilung (rms) wenigstens gleich 30 nm beträgt.

9. Substrat nach einem der vorstehenden Ansprüche, **dadurch gekennzeichnet, dass** die transparente, elektrisch leitende Schicht aus einem Sn-, Zn- oder Indotierten Oxid, wie SnO₂:F, SnO₂:Sb, ZnO:Al, ZnO:Ga, InO:Sn, ZnO:B oder ZnO:In besteht.

10. Substrat nach einem der vorstehenden Ansprüche, **dadurch gekennzeichnet, dass** die transparente, elektrisch leitende Schicht aus SnO₂:F besteht.

11. Substrat nach einem der vorstehenden Ansprüche, **dadurch gekennzeichnet, dass** zwischen dem transparenten Glassubstrat und der transparenten, elektrisch leitenden Schicht wenigstens eine Schicht aus wenigstens einem Nitrid oder O-xinitrid oder Oxid oder Oxicarbid eingefügt ist.

12. Substrat nach einem der vorstehenden Ansprüche, **dadurch gekennzeichnet, dass** eine Sperrschicht gegen das Wandern der Alkalien des Glases und mit guter Haftung an diesem direkt das transparente Glassubstrat bedeckt.

13. Substrat nach Anspruch 12, **dadurch gekennzeichnet, dass** eine Mischschicht aus einer Verbindung aus einem chemischen mineralischen Element, das die Sperrschicht bildet, und einem chemischen mineralischen Element, das die transparente, elektrisch leitende Schicht bildet, direkt die Sperrschicht bedeckt.

14. Substrat nach einem der Ansprüche 12 oder 13, **dadurch gekennzeichnet, dass** die Sperrschicht aus Siliziumoxicarbid SiOC mit einer Dicke zwischen 5 und 80 nm besteht.

15. Substrat nach einem der Ansprüche 13 bis 14, **dadurch gekennzeichnet, dass** die Mischschicht aus Silizium- und Zinnoxid mit einer Dicke zwischen 3 und 65 nm besteht.

16. Verfahren zur Herstellung eines Substrats nach einem der vorstehenden Ansprüche, **dadurch gekennzeichnet, dass** die mögliche Sperrschicht, mögliche Mischschicht und mögliche Schicht aus dem die transparente, elektrisch leitende Schicht bildenden nicht dotierten Oxid und die transparente, elektrisch leitende Schicht durch aufeinanderfolgende chemische Gasphasenabscheidungen erhalten werden.

17. Photovoltaikmodul, das ein Substrat nach einem der Ansprüche 1 bis 15 umfasst.

18. In Form gebrachte Heizscheibe, die ein Substrat nach einem der Ansprüche 1 bis 15 umfasst.

19. Elektrode einer Flachlampe, die ein Substrat nach einem der Ansprüche 1 bis 15 umfasst.

20. Vorrichtung mit organischen Leuchtdioden, die ein Substrat nach einem der Ansprüche 1 bis 15 umfasst.

## Claims

1. Transparent glass substrate, associated with a transparent electro-conductive layer capable of forming a photovoltaic module electrode composed of a doped oxide, which is noteworthy in that
- by taking, over a surface of 2 cm x 2 cm, at least five 10 µm x 10 µm (512 pixels x 512 pixels) images by atomic force microscope (AFM) of the face of said transparent electro-conductive layer opposite to said transparent glass substrate, by means of an AFM point of radius of curvature at the most equal to 10 nm,
- then, for each of the at least five images, calculation by bilinear interpolation of the level contour map with a pitch of 1 nm at an oversampling rate of 4 points per pixel, only keeping those bounding a region containing a single local maximum, no local minimum, and closed,
- the average of the values obtained for the at least five images of the mean isoperimetric ratio (RIm) defined for areas of the level contour curves in the range between 2000 nm² and 8000 nm² as the perimeter of these level contours squared divided by 4 times n times their area, is at the most equal to 1.17, and
- the average of the values obtained for the at least five images of the standard deviation of the distribution of the heights (rms value) is in the range between 20 and 200 nm, **characterized in that** the transparent electro-conductive layer composed of a doped oxide directly covers a layer of the same oxide but undoped, the combined thickness of the two layers of the undoped oxide and the doped oxide being in the range between 300 and 1600 nm, preferably at the most equal to 1100 nm and in a particularly preferred manner equal to 900 nm, and the ratio of the thicknesses of the two layers being in the range between 1:4 and 4:1.

2. Substrate according to Claim 1, **characterized in that** the mean isoperimetric ratio is at the most equal to 1.16.

3. Substrate according to either one of the preceding claims, **characterized in that** the mean isoperimetric ratio is at the most equal to 1.15.

4. Substrate according to any one of the preceding claims, **characterized in that** the mean isoperimetric ratio is at the most equal to 1.14.

5. Substrate according to any one of the preceding claims, **characterized in that** the mean isoperimetric ratio is at the most equal to 1.13.

6. Substrate according to any one of the preceding claims, **characterized in that** the mean isoperimetric ratio is at the most equal to 1.12.

7. Substrate according to any one of the preceding claims, **characterized in that** the standard deviation of the distribution of the heights (rms value) is at the most equal to 100, and preferably 70 nm.

8. Substrate according to any one of the preceding claims, **characterized in that** the standard deviation of the distribution of the heights (rms value) is equal to at least 30 nm.

9. Substrate according to any one of the preceding claims, **characterized in that** the transparent electro-conductive layer is composed of a doped oxide of Sn, Zn or In, such as SnO₂:F, SnO₂:Sb, ZnO:Al, ZnO:Ga, InO:Sn, ZnO:B or ZnO:In.

10. Substrate according to any one of the preceding claims, **characterized in that** the transparent electro-conductive layer is composed of SnO₂:F.

11. Substrate according to any one of the preceding claims, **characterized in that**, between the transparent glass substrate and the transparent electro-conductive layer, at least one layer of at least one nitride or oxynitride, or oxide or oxycarbide, is inserted.

12. Substrate according to any one of the preceding claims, **characterized in that** a barrier layer against the migration of alkalines from the glass and with a good adhesion to the latter directly covers the transparent glass substrate.

13. Substrate according to Claim 12, **characterized in that** a mixed layer of a compound of a mineral chemical element constituent of the barrier layer and of a mineral chemical element constituent of the transparent electro-conductive layer directly covers the barrier layer.

14. Substrate according to either one of Claims 12 and 13, **characterized in that** the barrier layer is made of silicon oxycarbide SiOC with a thickness in the range between 5 and 80 nm.

15. Substrate according to either one of Claims 13 and 14, **characterized in that** the mixed layer is composed of silicon and tin oxide with a thickness in the range between 3 and 65 nm.

16. Method of fabrication of a substrate according to any one of the preceding claims, **characterized in that** the potential barrier layer, mixed layer and layer of the undoped oxide constituent of the transparent electro-conductive layer, and the transparent electro-conductive layer are obtained by successive chemical vapor-phase depositions.

17. Photovoltaic module comprising a substrate according to any one of Claims 1 to 15.

18. Structured heated glass, comprising a substrate according to any one of Claims 1 to 15.

19. Electrode for a plane lamp comprising a substrate according to any one of Claims 1 to 15.

20. Device using organic light-emitting diodes comprising a substrate according to any one of Claims 1 to 15.
